(19) **Europäisches Patentamt**

**European Patent Office**

**Office européen des brevets**

(11) **EP 1 058 324 A1**

(12) **EUROPEAN PATENT APPLICATION**
published in accordance with Art. 158(3) EPC

(43) Date of publication:
06.12.2000 Bulletin 2000/49

(51) Int. Cl.⁷: **H01L 43/08**, G01R 33/09, G11B 5/39

(21) Application number: 98950391.7

(22) Date of filing: 26.10.1998

(86) International application number:
PCT/JP98/04840

(87) International publication number:
WO 00/25371 (04.05.2000 Gazette 2000/18)

(84) Designated Contracting States:
DE FR

(71) Applicant:
MITSUBISHI DENKI KABUSHIKI KAISHA
Tokyo 100-8310 (JP)

(72) Inventors:
• FUKAMI, Tatsuya,
Mitsubishi Denki Kabushiki Kaisha
Tokyo 100-8310 (JP)

• MAEDA, Yoshinobu,
Mitsubishi Denki K.K.
Tokyo 100-8310 (JP)

(74) Representative:
Popp, Eugen, Dr. et al
MEISSNER, BOLTE & PARTNER
Postfach 86 06 24
81633 München (DE)

(54) **MAGNETORESISTANT DEVICE AND A MAGNETIC SENSOR COMPRISING THE SAME**

(57) A magnetoresistance effect element of the present invention includes a structure in which a magnetic layer and a non-magnetic layer containing Cu as a major component are alternately and repeatedly laminated; a magnetoresistance effect film in which a thickness of said non-magnetic layer is set to be near a thickness at which an MR ratio attains a second maximum, said magnetoresistance effect film further satisfying the following conditions; the magnetic layer comprises $Co_{1-x}Fe_x$ $(0.05 \leq x \leq 0.5)$; and the magnetic layers are a repetition of a thin magnetic layer and a thick magnetic layer having thicknesses modulated layer by layer with the non-magnetic layer intervening therebetween, and said thin magnetic layer having a thickness within a range from 4.5 Å to 8 Å. In the magnetoresistance effect element which is used by applying a magnetic field, central magnetic field of which is offset in a specific direction, the magnetoresistance element is initialized in advance in the above-mentioned offset magnetic field direction. The magnetoresistance effect element is subjected to linear patterning, a longitudinal direction of which is perpendicular to a direction of magnetic field change to be detected. Thus, the magnetoresistance effect element, in which MR ratio is large, hysteresis of magnetic field is small and stability under high temperature is attained, can be obtained.

FIG. 1

1 PERIOD

**Description**

TECHNICAL FIELD

The present invention relates to a magnetoresistance effect element for use in a magnetic sensor or the like.

BACKGROUND ART

A magnetoresistance effect is a phenomenon in which resistance changes in accordance with the strength or the orientation of an applied magnetic field. Since the old days, a ferromagnetic thin film such as a permalloy thin film is known to have this effect. However, its resistance changing ratio is about 3 % at the maximum and, for practical applications, a material having a larger resistance changing ratio has been desired.

In recent years, it has been found out that a resistance changing ratio near to 50 % can be obtained at room temperature in a Co/Cu (Co thickness 15 Å, Cu thickness 9 Å) artificial grating film. However, with this construction, the saturation magnetic field has an extremely large value of 5 kOe, so that it has been difficult to apply it to a device such as a magnetic sensor or a magnetic head.

On the other hand, Japanese Unexamined Patent Publication No. 06-112078/1994 discloses that a large resistance changing ratio of about 28 % can be obtained with a comparatively small magnetic field of 1 kOe by setting the Cu thickness to be 20 Å in a Co/Cu artificial grating film. The resistance changing ratio (MR ratio) in the Co/Cu artificial grating film attains its first maximum when the Cu thickness is about 9 Å and attains its second maximum when the Cu thickness is about 20 Å. At this second maximum, a large resistance changing ratio compared with a permalloy thin film can be obtained with a comparatively small saturation magnetic field, so that application to various devices is expected. However, although the second maximum of this Co/Cu artificial grating film is excellent in stability under a high temperature and is practical also in this respect, an MR curve (curve showing change in the resistance value relative to the applied magnetic field; hereafter referred to as MR (magnetoresistance) curve) at the second maximum has a large hysteresis. In other words, the resistance value is not uniquely determined for the magnetic field, so that it is not suited for a rotation sensor having a low rotation number or a magnetic head, and its usage is extremely limited.

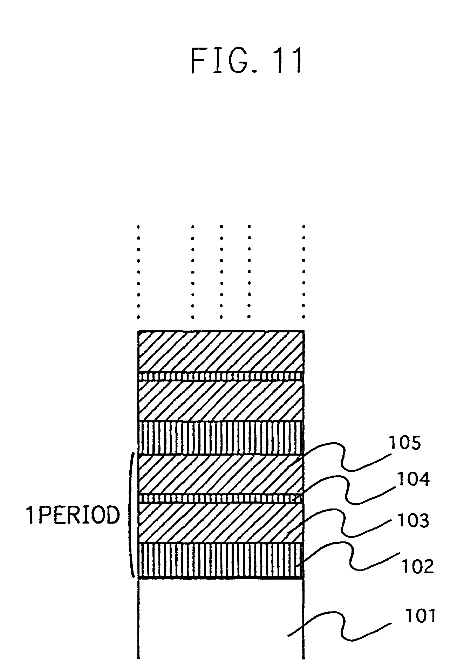

As a method for solving this problem, J. Appl. Phys. 79(9) p.7090-7094 "Giant magnetoresistance in Co/Cu multilayers with Co layers of alternating thicknesses: Reduction of magnetoresistive hysteresis" discloses changing the Co layer thickness layer by layer. According to this, the hysteresis is greatly reduced. Fig. 11 shows a cross-sectional model view of this magnetoresistance effect film. In Fig. 11, an Si substrate 101 having silicon oxide thereon, a thick Co layer 102, Cu layers 103 and 105 being non-magnetic layers, and a thin Co layer 104 are shown. The thick Co layer has a thickness of 10 to 30 Å. With the four layers 102 to 105 constituting one period, the magnetoresistance film is formed by repeating this structure for ten periods, as illustrated in Fig. 11.

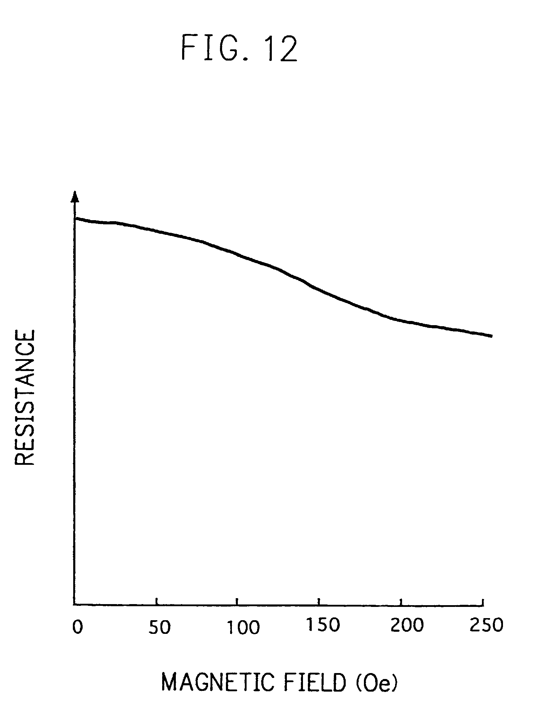

Fig. 12 shows an MR curve depicted by the magnetoresistance effect film when the thin Co layer has a thickness of 2.5 to 3 Å, showing that there is little hysteresis.

By thus modulating the Co layer thickness, it is possible to reduce the hysteresis greatly. However, this film has a large problem that it lacks in stability. In other words, it has a problem that, although it shows good properties immediately after film formation, the resistance changing ratio is deteriorated with time.

The present invention has been made in order to solve the above-mentioned problems, and an object thereof is to provide a magnetoresistance effect element which comprises a repeated laminate structure having magnetic layers and non-magnetic layers, which does not change with time and especially has stability even under a high temperature, and which has reduced hysteresis. Another object is to provide a magnetic sensor using the obtained magnetoresistance effect element and being highly sensitive and highly reliable.

DISCLOSURE OF THE INVENTION

The first magnetoresistance effect element according to the present invention comprises a structure in which a magnetic layer and a non-magnetic layer containing Cu as a major component are alternately and repeatedly laminated, and has a magnetoresistance effect film in which a thickness of said non-magnetic layer is set to be near a thickness at which an MR ratio attains a second maximum, said magnetoresistance effect film further satisfying the following conditions:

(a) the magnetic layer comprises $Co_{1-x}Fe_x$ ($0.05 \leq x \leq 0.5$); and
(b) the magnetic layers are a repetition of a thin magnetic layer and a thick magnetic layer having thicknesses modulated layer by layer with the non-magnetic layer intervening therebetween, and said thin magnetic layer has a thickness within a range from 4.5 Å to 8 Å. Therefore, it is an element which does not change with time and especially has stability even under a high temperature, and which has reduced hysteresis.

The second magnetoresistance effect element according to the present invention comprises a structure in which a magnetic layer and a non-magnetic layer containing Cu as a major component are alternately and repeatedly laminated, and has a magnetoresistance effect film in which a thickness of said non-magnetic layer is set to be near a thickness at which an MR ratio attains a second maximum, and the magnetoresistance effect element is operated by applying a magnetic field whose central magnetic field is offset in a specific direction, said magnetoresistance effect element being initialized in advance in said offset magnetic field direction. Therefore, it is an element which does not change with time and especially has stability even under a high temperature, and which has reduced hysteresis.

The third magnetoresistance effect element of the present invention comprises a structure in which a magnetic layer and a non-magnetic layer containing Cu as a major component are alternately and repeatedly laminated, and has a magnetoresistance effect film in which a thickness of said non-magnetic layer is set to be near a thickness at which an MR ratio attains a second maximum, wherein the magnetoresistance effect film is formed to have a linear pattern, a longitudinal direction of which is perpendicular to a direction of magnetic field change to be sensed. Therefore, it is an element which does not change with time and especially has stability even under a high temperature, and which has reduced hysteresis.

The magnetic sensor according to the present invention has a plurality of magnetoresistance effect elements according to any one of claims 1 to 3, disposed in a periphery of an external magnetic field. Each magnetoresistance effect element is an element which does not change with time and especially has stability even under a high temperature, and which has reduced hysteresis. Therefore, a highly sensitive and highly reliable sensor can be obtained.

BRIEF DESCRIPTION OF THE DRAWINGS

Fig. 1 is a cross-sectional model view illustrating a construction of a magnetoresistance effect film according to the first embodiment of the present invention; Fig. 2 is a view illustrating an example of a magnetic field-resistance loop depicting characteristics of the magnetoresistance effect film according to the first embodiment of the present invention; and Fig. 3 is a view showing a resistance changing ratio (Fig. 3(a)) and a hysteresis magnetic field (Fig. 3(b)) when the thickness of the thin magnetic layer and the Co-Fe alloy composition of the magnetic layer are changed in the magnetic resistance effect film according to the first embodiment of the present invention.

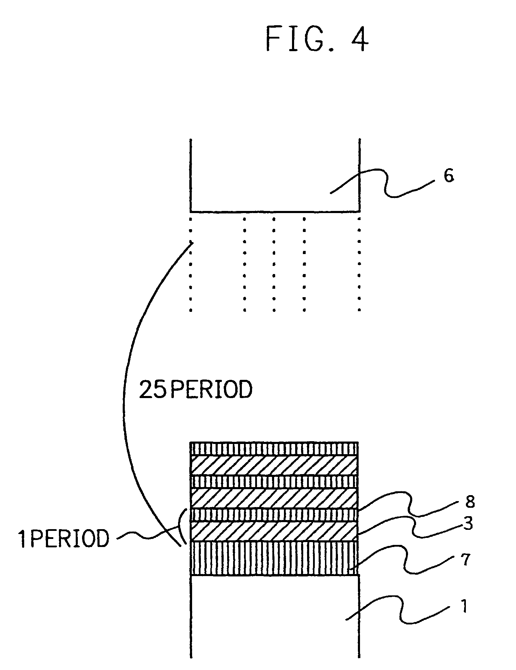

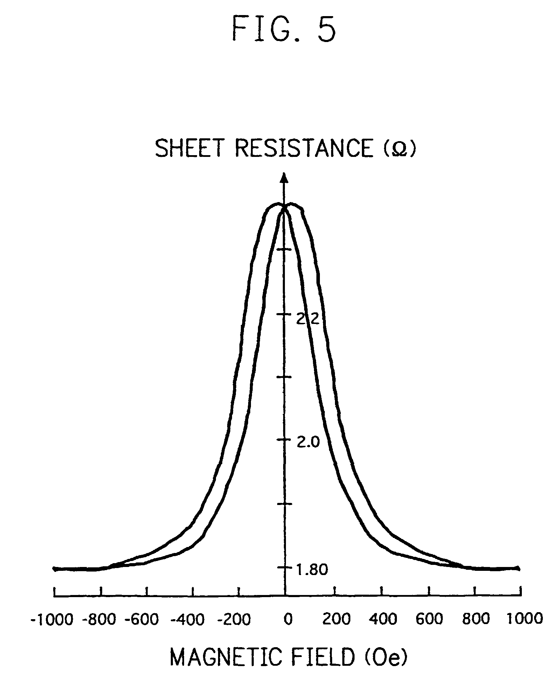

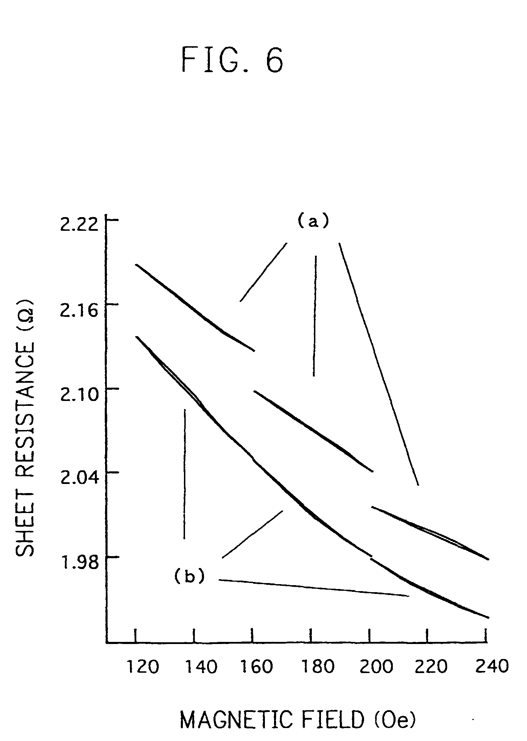

Fig. 4 is a cross-sectional model view illustrating a construction of a magnetoresistance effect film according to the third embodiment of the present invention; Fig. 5 is a view depicting an MR curve of the magnetoresistance effect film according to the third embodiment of the present invention (when a large magnetic field is applied); and Fig. 6 is a view illustrating an MR curve of the magnetoresistance effect film concerning the third embodiment of the present invention (when a biased small magnetic field is applied).

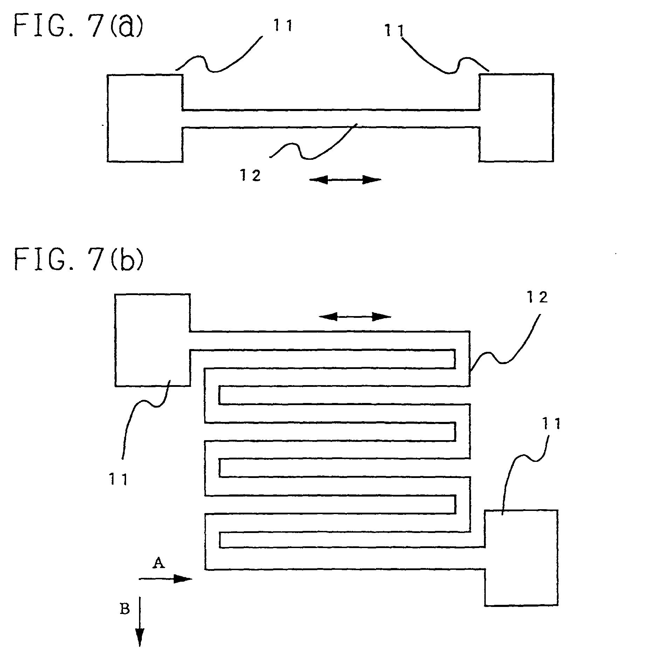

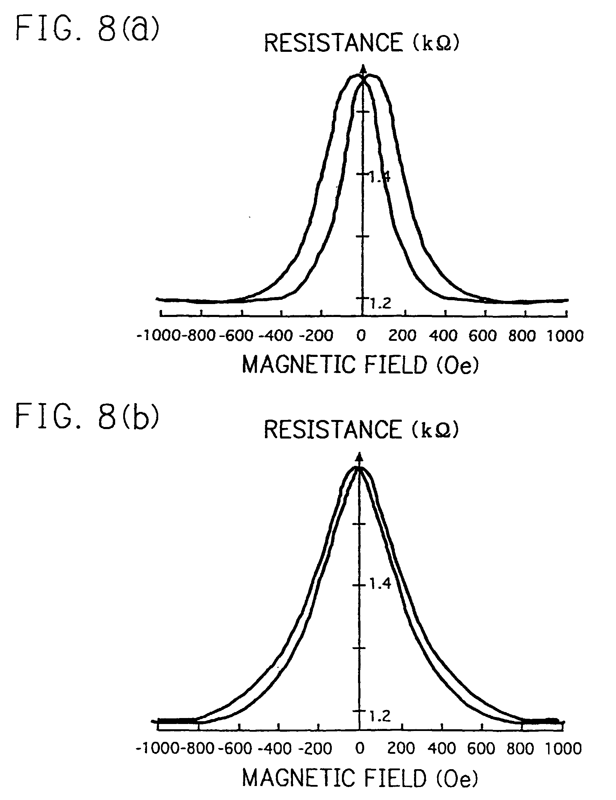

Fig. 7 is a view illustrating an example of a pattern of a magnetoresistance effect film according to the fourth embodiment of the present invention; and Fig. 8 is an MR curve of the patterned magnetoresistance effect element according to the fourth embodiment of the present invention ((a) the case where the pattern is parallel to an applied magnetic field, (b) the case where the pattern is perpendicular to the applied magnetic field).

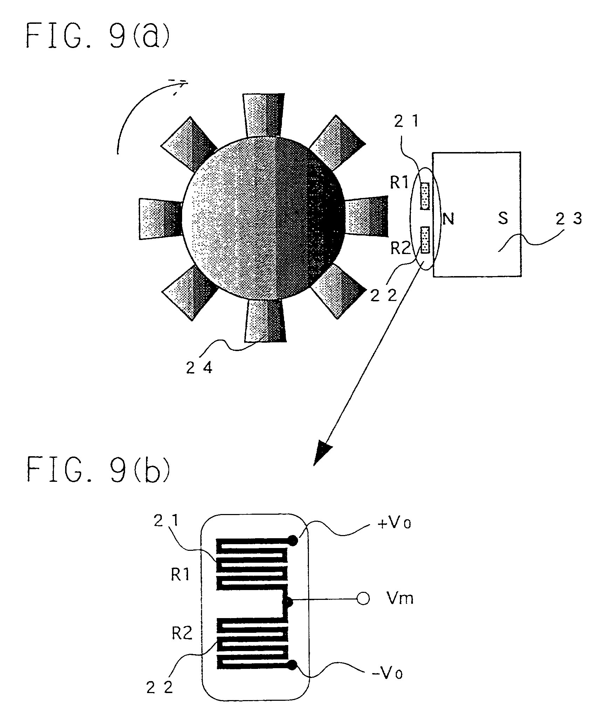

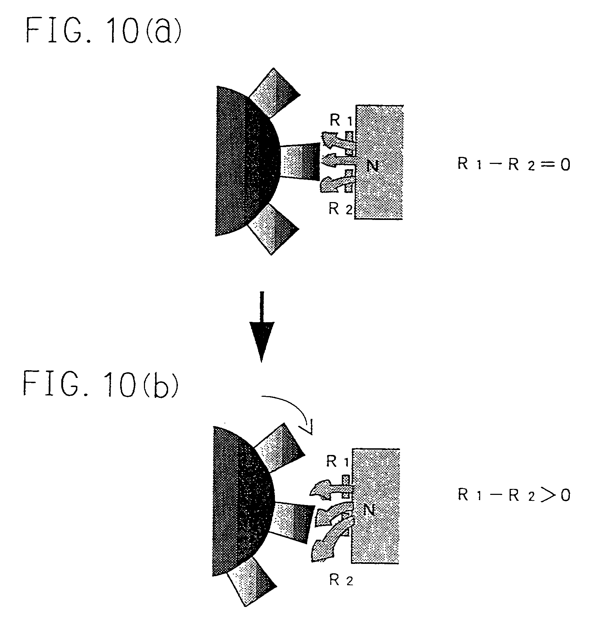

Fig. 9 is a view illustrating a construction of a rotation sensor as an example of a magnetic sensor according to the fifth embodiment of the present invention; and Fig. 10 is a view for explaining a measurement principle of the rotation sensor.

Fig. 11 is a cross-sectional model view illustrating a construction of a magnetoresistance effect film in the prior art; and Fig. 12 is a view showing magnetic field-resistance loop characteristics of the magnetoresistance effect film in the prior art.

BEST MODE FOR CARRYING OUT THE INVENTION

In the present invention, in order to obtain a magnetoresistance effect element having a large magnetoresistance changing ratio and a small hysteresis magnetic field together with stability even under a high temperature and being suitable, for example, for a magnetic sensor, in an element having a structure in which a magnetic layer and a non-magnetic layer containing Cu as a major component are alternately and repeatedly laminated, a thickness of said non-magnetic layer is set to be near a thickness at which an MR ratio attains a second maximum, the magnetic layer comprises $Co_{1-x}Fe_x$ ($0.05 \leq x \leq 0.5$), the magnetic layers have thicknesses modulated layer by layer, and the thin, magnetic layer has a thickness within a range from 4.5 Å to 8 Å.

Also, in a magnetoresistance effect element having a structure in which a magnetic layer and a non-magnetic layer containing Cu as a major component are alternately and repeatedly laminated, in which a thickness of said non-magnetic layer is set to be near a thickness at which an MR ratio attains a second maximum, and in which a magnetic field whose central magnetic field is offset in a specific direction is applied for use, said magnetoresistance effect element being initialized in advance in said offset magnetic field direction, thereby reducing the hysteresis.

Also, in a magnetoresistance effect element having a structure in which a magnetic layer and a non-magnetic layer containing Cu as a major component are alternately and repeatedly laminated, in which a thickness of said non-magnetic layer is set to be near a thickness at which an MR ratio attains a second maximum, and in which the magnetoresistance effect film is formed to have a linear pattern, a longitudinal direction of said linear pattern is perpendicular to a direction of magnetic field change to be sensed, thereby reducing the hysteresis.

Further, the magnetic sensor according to the present invention, in which a magnetoresistance effect element constructed as above is mounted, has a large magnetoresistance changing ratio and a small hysteresis magnetic field, and also has stability even under a high temperature, so that a highly sensitive and highly reliable sensor is realized.

Hereafter, examples of the invention will be described with reference to the drawings.

EXAMPLE 1

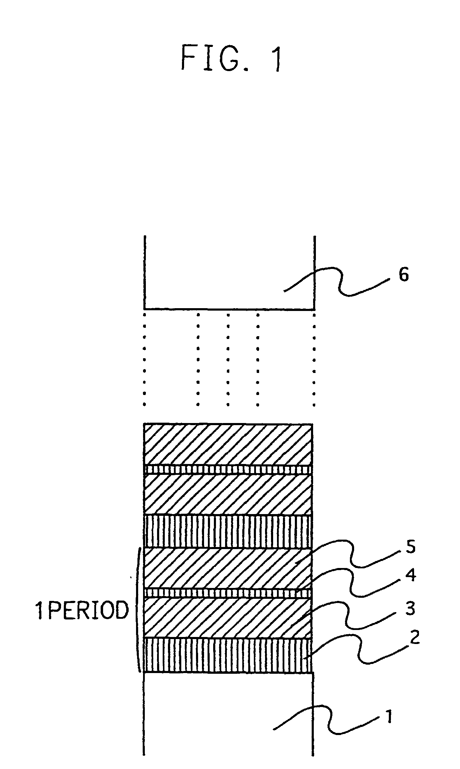

Fig. 1 shows a structure of a magnetoresistance effect film constituting a magnetoresistance effect element concerning the present invention. In Fig. 1, a substrate 1 such as Si or glass, a thick magnetic layer 2, non-magnetic layers 3 and 5 such as Cu containing Cu as a major component, a thin magnetic layer 4, and a silicon nitride film 6 (protective film) having a thickness of 3000 Å for preventing oxidation are shown. With the above-mentioned layers 2 to 5 constituting one period, the magnetoresistance effect film is constructed with a multi-layer film including several to several ten periods. The thick magnetic layer 2 and the thin magnetic layer 4 are made of the same material and only their thicknesses are different. The material for the thick magnetic layer 2 and the thin magnetic layer 4 is an alloy containing Co and Fe as major components. The Cu layers 3 and 5, which are non-magnetic layers, are made of the same material and have the same thickness within a preparation error range of a film forming apparatus. The thickness is set to be near a thickness at which the resistance changing ratio attains its second maximal value. Further, there are some cases in which a dielectric film such as silicon oxide or silicon nitride is disposed between the substrate 1 and the thick magnetic layer 2, and further there are some cases in which a buffer layer of several ten Å is disposed (not illustrated in Fig. 1). After the film formation, it was annealed in vacuum for 12 hours after the film preparation for stabilizing the film properties. The annealing temperature is a temperature at which a crystal structure goes into a stable state, and is suitably about 200°C.

The magnetoresistance effect film was prepared by sputtering by fixing the thickness of the thick magnetic layer to be 15 Å and varying the thickness of the thin magnetic layer and the CoFe alloy composition of the magnetic layer in matrix manner. The thickness of the thin magnetic layer was changed from 3 Å to 9 Å by 0.5 Å. On the other hand, regarding the CoFe alloy composition, the Fe content was changed from 0 to 60 at %. The number of periods was fixed to be 14, because the properties are not greatly changed if it was eight or more.

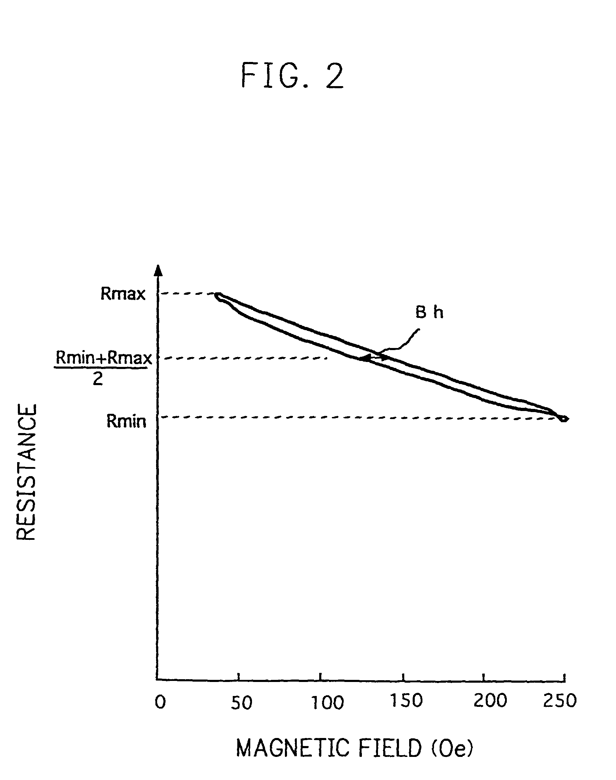

The magnetoresistance properties of the prepared magnetoresistance effect film was measured. The resistance measurement was conducted by using the four terminal method and applying a uniform magnetic field on the film by an electromagnet. The magnetic field was changed from 50 (Oe) through 250 (Oe) to 50 (Oe). Fig. 2 shows a model view illustrating a measured loop depicting a relationship between the magnetic field and the resistance (a portion of the MR curve). In this model view, hysteresis is drawn to a larger scale than the actual one for facilitating explanation of the later-mentioned hysteresis magnetic field. According as the magnetic field increases, the resistance decreases, and attains the minimum value Rmin at 250 (Oe) and the maximum value Rmax at 50 (Oe). At a midway magnetic field, the resistance value assumes different values in going and returning trips. The resistance changing ratio is defined as follows.

$$\text{Resistance changing ratio} = (Rmax - Rmin) / Rmin \times 100 \ (\%)$$

For estimation of the hysteresis, the hysteresis magnetic field is defined as the difference between the values of the magnetic field in going and returning trips at

$$(Rmin + Rmax) / 2$$

i.e. at a midpoint of the resistance. This hysteresis magnetic field is shown by Bh in Fig. 2. In application to a magnetic sensor, the properties required in the magnetoresistance effect film are a large resistance changing ratio and a small hysteresis magnetic field.

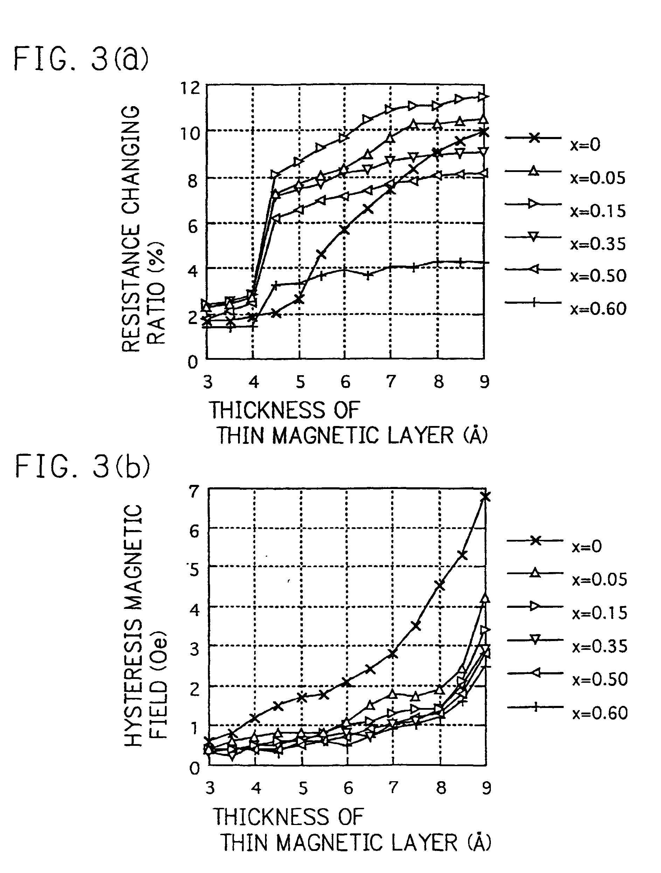

Fig. 3 shows the resistance changing ratio and the hysteresis magnetic field of the prepared magnetoresistance effect film. In Fig. 3(a), the horizontal axis represents the thickness of the thin CoFe magnetic layer, and the vertical axis represents the resistance changing rate, using the Fe content X of the CoFe alloy as a parameter. Irrespective of the Fe content X, the resistance changing ratio increases monotonously with respect to the thickness of the thin magnetic layer. Particularly, magnetoresistance effect films having an Fe content from 5 % to 50 % show a sharp rise in the resistance changing ratio when the thickness of the thin magnetic layer exceeds 4.5 Å. The magnetoresistance effect film having an Fe content of 60 % shows a small resistance changing ratio irrespective of the thickness of the thin magnetic layer.

Fig. 3(b) shows the hysteresis magnetic field of the prepared magnetoresistance effect film. In Fig. 3(b), the horizontal axis represents the thickness of the thin CoFe magnetic layer, and the vertical axis represents the hysteresis magnetic field, using the Fe content X of the CoFe alloy as a parameter. If X = 0, i.e. if the magnetic layer is made of Co alone, the hysteresis magnetic field is large as compared with the cases in which Fe is contained. If Fe is contained, the hysteresis magnetic field moderately increases when the thickness of the thin magnetic layer is less than 8 Å. However, when the thickness exceeds 8 Å, the hysteresis magnetic field sharply increases.

As shown above, from Figs. 3(a) and 3(b), it has been found out that a large magnetoresistance changing ratio and a small hysteresis magnetic field suitable for a magnetic sensor are obtained in a magnetoresistance effect film in which the Fe content is within the range from 5 % to 50 % and the thickness of the thin magnetic layer is within the range from 4.5 Å to 8 Å. In addition, these magnetoresistance effect films were left to stand at a high temperature of 150°C in vacuum for 1000 hours and thereafter the MR curve was measured again. An MR curve was obtained which was identical to the one before leaving it at a high temperature, thus confirming that the magnetoresistance effect film was a good one that does not change with time.

A magnetoresistance effect element constructed with the aforementioned magnetoresistance effect film is a good element applicable to a magnetic sensor.


EXAMPLE 2


In Example 1, the thickness of the thick magnetic layer was set to be 15 Å. In this Example, the thickness was set to be 30 Å. Regarding the hysteresis magnetic field, similar results were obtained as compared with the case in which the thickness of the thick magnetic layer was 15 Å. A totally similar tendency was observed with respect to the resistance changing ratio. However, irrespective of the thickness of the thin magnetic layer or the Fe content, the absolute value of the obtained resistance change was about 80 % of the resistance changing ratio obtained when the thickness of the thick magnetic layer was 15 Å. The MR curve did not change before and after being left to stand at a high temperature, in the same manner as in Example 1.


EXAMPLE 3


In Examples 1 and 2, an artificial grating magnetoresistance effect film was prepared in which the thickness of the magnetic layer was modulated layer by layer. In Examples 3 to 4, an artificial grating magnetoresistance effect film was prepared in which the thickness of the magnetic layer was not modulated.

An artificial grating magnetoresistance effect film was prepared in which a CoFe alloy layer containing 7 % of Fe in an atomic composition ratio and a Cu layer were alternately laminated. In this Example, a Si substrate was used as the substrate. However, the substrate may be a glass substrate or the like. The following magnetoresistance effect film was formed on this Si substrate. Fig. 4 shows its structure.

Protective film/...{CoFe(17Å)/Cu(22Å)}*25 periods/ CoFe(50 Å) / substrate

In Fig. 4, the first 50 Å CoFe on the substrate 1 is a buffer layer 7, and serves to allow the crystal orientation of the film laminated thereon to be in a good condition. However, this buffer layer 7 is not necessarily needed. A 22 Å Cu layer serving as the non-magnetic layer 3 and a 17 Å CoFe layer serving as the magnetic layer 8 were formed repeatedly for 25 pairs. The thickness 22 Å of the Cu layer is a thickness at which the MR ratio attains its second maximum. The films were formed by means of a DC magnetron sputter. In forming the film, an Ar gas was allowed to flow so as to have a pressure of 1 mm Torr. After the film was formed, annealing was performed in vacuum at an annealing temperature of 200°C for six hours. By performing the annealing, thermal stability is improved and the film can be applied to a device used under a high temperature. However, annealing is not essential in a device that is not used under a high temperature. The change in resistance of the magnetoresistance effect film relative to the magnetic field was measured by the four terminal method. The magnetic field was changed from -1 kOe through +1 kOe to -1 kOe. Fig. 5 shows the results of measurement, where the horizontal axis represents the magnetic field and the vertical axis represents the sheet resistance value of the magnetoresistance effect film. The obtained resistance changing ratio was 31 % and the saturation magnetic field showed a comparatively small value of 0.8 kOe, though hysteresis was present.

An artificial grating magnetoresistance effect film has the largest resistance in the vicinity of zero magnetic field. Therefore, if it is applied to a device, it is often more advantageous to apply a biased magnetic field. If a non-biased magnetic field, i.e. a magnetic field that oscillates around zero, is applied, the resistance decreases whether the absolute value of the magnetic field increases to the plus side or to the minus side, whereby the resistance change will be less than half as compared with the case in which the biased magnetic field is applied. Further, there will not be a one-to-one correspondence between the magnetic field and the resistance.

Fig. 6 shows MR curves as measured within biased small magnetic field ranges. The width of magnetic field variation was ±20 (Oe), and the center magnetic fields of the biased magnetic fields, i.e. the applied magnetic fields, were 140, 180, and 220 (Oe). These center magnetic fields were selected because the magnetoresistance effect film has the largest magnetic field sensitivity near the above-mentioned magnetic fields. However, if measurement is made within a small magnetic field range such as above, the MR curve differs depending on the direction of the magnetic field applied before the measurement, i.e. the direction of the magnetic field for initialization. Fig. 6 shows a case (a) in which the film is initialized by a magnetic field of -800 (Oe) and a case (b) in which the film is initialized by a magnetic field of +800 (Oe) before the measurement As will be apparent from Fig. 6, in the case (a) where the film was initialized by a magnetic field of -800 (Oe), the influence of hysteresis is conspicuous. For example, the resistance value at 160 (Oe) differs depending on a sweeping region of the magnetic field (the gap between adjacent MR curves is large), failing to give one-to-one correspondence between the magnetic field and the resistance value. Also, it will be understood from Fig. 6 that, in the case (a) in which the film is initialized by a magnetic field of -800 (Oe), the magnetic field sensitivity is small as compared with the case (b) in which the film is initialized by a magnetic field of +800 (Oe). At -800 (Oe) or +800 (Oe), the resistance value is saturated, as will be understood from Fig. 5, so that initialization by a magnetic field exceeding the above gave the same results. On the other hand, if the film is initialized by a magnetic field having a smaller absolute value than -800 (Oe) or +800 (Oe), hysteresis remains. If the applied voltage is negative, it is preferable to initialize the film by a magnetic field of -800 (Oe).

EXAMPLE 4

For example, a magnetoresistance effect film prepared in Example 3 was patterned by photolithography. For application to various devices, it is not too much to say that the patterning process is essential. This is because a large resistance value suitable for individual devices can be obtained with a small area by performing a patterning process. Fig. 7 shows an example of patterning. In Figs. 7(a) and 7(b), pads (11) for measuring the resistance change and a sensing section 12 whose resistance changes in accordance with the change in the magnetic field are shown. In Fig. 7(a), the right and left directions on the document sheet are the longitudinal directions of the pattern (shown by ⇔ in Fig. 7(a)). On the other hand, in Fig. 7(b), the pattern is complex because it is meandering. However, the right and left directions on the document sheet can be generally considered as being the longitudinal directions (⇔) of the pattern. Fig. 8 shows change in resistance as measured by applying a magnetic field to a magnetoresistance effect film patterned as in the above-mentioned Fig. 7(b). The direction of the applied magnetic field is parallel (direction (A) in Fig. 7) to the longitudinal direction of the pattern in Fig. 8(a), and is perpendicular thereto (direction (B) in Fig. 7) in Fig. 8(b). The pattern width at this time is 7 μm. It will be understood that the hysteresis is greatly reduced if the magnetic field is applied perpendicularly to the longitudinal direction of the pattern. This is considered to be mainly due to the influence of morphological anisotropy caused by patterning.

EXAMPLE 5

In the above-mentioned Example 4, an example was explained in which the magnetoresistance effect film prepared in Example 3 is patterned. However, the magnetoresistance effect films prepared in Examples 1 and 2 may be patterned for use. Further, reduction in hysteresis can be obtained by patterning the magnetoresistance effect film explained in the prior art and applying a magnetic field perpendicularly to the longitudinal direction of the pattern.

EXAMPLE 6

An example will be explained in which a rotation sensor, which is one of the magnetic sensors, is constructed by disposing a magnetoresistance effect element having electrode pads and the like formed in addition to the magnetoresistance effect film prepared in the above-mentioned Example 1, 2, or 3 and patterned as in Example 4. Fig. 9 is a view for explaining a construction of the rotation sensor. In Fig. 9(a), the rotation sensor includes magnetoresistance effect elements 21, 22 and a permanent magnet 23, where a gear 24 made of a magnetic material such as iron is mounted to a rotation axis of a rotating body to be sensed and rotates together with the rotating body. The two magnetoresistance effect elements 21, 22 have the same properties (resistance changing ratio, resistance value, and MR curve), have their magnetosensitive directions only within an element surface, and are disposed symmetrically with respect to the central axis of the permanent magnet 23. The resistance values of the magnetoresistance effect elements 21, 22 are assumed to be R1, R2, respectively. Fig. 9(b) is a model view in which an X portion of Fig. 9(a) is viewed from the gear side. As shown in Fig. 9(b), by incorporating the two magnetoresistance effect elements into a Wheatstone bridge, the difference in resistance between the two elements can be sensed as a central point voltage Vm of the Wheatstone bridge.

Fig. 10 is a view for explaining a measurement principle of the rotation sensor. In Fig. 10(a), the magnetic fields applied to the two magnetoresistance effect elements in the element surface have the same magnitude, so that the resistance values of the two elements are the same ( R1 - R2 = 0 ). When the gear rotates in a clockwise direction to shift from Fig. 10(a) to Fig. 10(b), the magnetic flux from the permanent magnet turns downwards to reduce the absolute value of the magnetic field applied to the element 21. On the other hand, the absolute value of the magnetic field applied to the element 22 increases, thereby producing difference in resistance. At this time, R1 - R2 > 0 . As described above, the teeth of the gear pass over GMR by the rotation of the rotating body and as a result, the direction of the magnetic flux generated from the permanent magnet is changed by passage of the gear which is a magnetic substance. This change is sensed by the elements 21, 22.

The rotation sensor according to this embodiment is highly sensitive and highly reliable as a magnetic sensor because the elements constituting the sensor are elements prepared according to the above-mentioned examples and do not change with time, have stability even at a high temperature, and have reduced hysteresis.

INDUSTRIAL APPLICABILITY

The magnetoresistance effect element according to the present invention is utilized, for example, in a magnetic sensor such as a rotation sensor to be mounted in an automobile.

**Claims**

1. A magnetoresistance effect element comprising:

   a structure in which a magnetic layer and a non-magnetic layer containing Cu as a major component are alternately and repeatedly laminated; a magnetoresistance effect film in which a thickness of said non-magnetic layer is set to be near a thickness at which an MR ratio attains a second maximum, said magnetoresistance effect film further satisfying the following conditions;

   (a) the magnetic layer comprises $Co_{1-x}Fe_x(0.05 \leq x \leq 0.5)$; and
   (b) the magnetic layers are a repetition of a thin magnetic layer and a thick magnetic layer, having thicknesses modulated layer by layer with the non-magnetic layer intervening therebetween, and said thin magnetic layer having a thickness within a range from 4.5 Å to 8 Å.

2. A magnetoresistance effect element comprising:

   a structure in which a magnetic layer and a non-magnetic layer containing Cu as a major component are alternately and repeatedly laminated; a magnetoresistance effect film in which a thickness of said non-magnetic layer is set to be near a thickness at which an MR ratio attains a second maximum; said magnetoresistance effect element being operated by applying a magnetic field whose central magnetic field is offset in a specific direction; and said magnetoresistance effect element being initialized in advance in said offset magnetic field direction.

3. A magnetoresistance effect element comprising:

   a structure in which a magnetic layer and a non-magnetic layer containing Cu as a major component are alternately and repeatedly laminated; a magnetoresistance effect film in which a thickness of said non-magnetic layer is set to be near a thickness at which an MR ratio attains a second maximum, wherein the magnetoresistance effect film is formed to have a linear pattern; and a longitudinal direction of the linear pattern being perpendicular to a direction of magnetic field change to be sensed.

4. A magnetic sensor mounting a plurality of magnetoresistance effect elements according to any one of claims 1 to 3, being disposed in a periphery of an external magnetic field.

# FIG. 1

# FIG. 2

## FIG. 3(a)

THICKNESS OF
THIN MAGNETIC LAYER (Å)

## FIG. 3(b)

THICKNESS OF
THIN MAGNETIC LAYER (Å)

# FIG. 4

25 PERIOD

1 PERIOD

8
3
7
1

6

# FIG. 5

SHEET RESISTANCE (Ω)

MAGNETIC FIELD (Oe)

# FIG. 6

FIG. 7(a)

FIG. 7(b)

FIG. 8(a)

RESISTANCE (kΩ)

-1000 -800 -600 -400 -200　0　200　400　600　800　1000

MAGNETIC FIELD (Oe)

FIG. 8(b)

RESISTANCE (kΩ)

-1000 -800 -600 -400 -200　0　200　400　600　800　1000

MAGNETIC FIELD (Oe)

15

FIG. 9(a)

FIG. 9(b)

FIG. 10(a)

$R_1 - R_2 = 0$

FIG. 10(b)

$R_1 - R_2 > 0$

# FIG. 11

1PERIOD

105

104

103

102

101

# FIG. 12

## INTERNATIONAL SEARCH REPORT

| | International application No. |
|---|---|
| | PCT/JP98/04840 |

A. CLASSIFICATION OF SUBJECT MATTER
   Int.Cl⁶ H01L43/08, G01R33/09, G11B5/39

According to International Patent Classification (IPC) or to both national classification and IPC

B. FIELDS SEARCHED

Minimum documentation searched (classification system followed by classification symbols)
   Int.Cl⁶ H01L43/08, H01F10/08-10/30, G11B5/39

Documentation searched other than minimum documentation to the extent that such documents are included in the fields searched
   Jitsuyo Shinan Koho        1926-1996   Toroku Jitsuyo Shinan Koho   1994-1998
   Kokai Jitsuyo Shinan Koho  1971-1998   Jitsuyo Shinan Toroku Koho   1996-1998

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP, 6-112078, A (Sony Corp.),<br>22 April, 1994 (22. 04. 94),<br>Par. Nos. [0028] to [0030] ; Fig. 6<br>Par. Nos. [0028] to [0030] ; Fig. 6<br>(Family: none) | 3-4<br>1-2 |
| Y | JP, 8-201492, A (Matsushita Electric Industrial Co.,Ltd.),<br>9 August, 1996 (09. 08. 96),<br>Par. Nos. [0013] to [0021] ; Figs. 1 to 3<br>(Family: none) | 3-4 |
| Y | JP, 8-315324, A (Sony Corp.),<br>29 November, 1996 (29. 11. 96),<br>Par. Nos. [0030] to [0035] ; Figs. 1 to 3<br>(Family: none) | 3 |

[x] Further documents are listed in the continuation of Box C.   ☐ See patent family annex.

| * | Special categories of cited documents: |
|---|---|
| "A" | document defining the general state of the art which is not considered to be of particular relevance |
| "E" | earlier document but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 13 January, 1999 (13. 01. 99) | 26 January, 1999 (26. 01. 99) |

| Name and mailing address of the ISA/<br>    Japanese Patent Office | Authorized officer |
|---|---|
| Facsimile No. | Telephone No. |

Form PCT/ISA/210 (second sheet) (July 1992)

**INTERNATIONAL SEARCH REPORT**

International application No.

PCT/JP98/04840

C (Continuation). DOCUMENTS CONSIDERED TO BE RELEVANT

| Category* | Citation of document, with indication, where appropriate, of the relevant passages | Relevant to claim No. |
|---|---|---|
| A | Journal of Applied Physics, Vol. 79, No. 9, (1996), H. Holloway and D.J. Kubinski "Giant magnetoresistance in Co/Cu multilayers with Co layers of alternating thicknesses: Reduction of magnetoresistive hysteresis", p.7090-7094 | 1 |
| A | JP, 5-175572, A (Hitachi,Ltd.), 13 July, 1993 (13. 07. 93), Claim 1 ; Par. Nos. [0010], [0011] (Family: none) | 2 |
| A | JP, 8-78756, A (NEC Corp.), 22 March, 1996 (22. 03. 96), Par. Nos. [0025] to [0029] ; Figs. 1, 2 & EP, 675554, A1 | 2 |

Form PCT/ISA/210 (continuation of second sheet) (July 1992)